(19) Europäisches Patentamt
European Patent Office
Office européen des brevets

(11) Numéro de publication: **0 178 693 B1**

(12) **FASCICULE DE BREVET EUROPEEN**

(45) Date de publication de fascicule du brevet: **02.01.92**

(51) Int. Cl.[5]: **C08G 73/06**, C08G 61/12, C25B 3/10, H01B 1/12

(21) Numéro de dépôt: **85200933.1**

(22) Date de dépôt: **13.06.85**

(54) **Polymères électroconducteurs dérivés de monomères polycycliques hétéroaromatiques, procédé pour leur préparaton et matériaux électroconducteurs composites comprenant ces polymères.**

(30) Priorité: **15.06.84 BE 213150**

(43) Date de publication de la demande: **23.04.86 Bulletin 86/17**

(45) Mention de la délivrance du brevet: **02.01.92 Bulletin 92/01**

(84) Etats contractants désignés: **AT BE CH DE FR GB IT LI NL SE**

(56) Documents cités: **EP-A- 0 099 984**

(73) Titulaire: **SOLVAY**
**Rue du Prince Albert, 33**
**B-1050 Bruxelles(BE)**

(72) Inventeur: **Lazzaroni, Roberto**
**Rue Bois Sainte Marie, 108**
**B-5700 Sambreville(BE)**
Inventeur: **Riga, Joseph**
**Rue Moineresse, 1A**
**B-5131 Andenne (Thon)(BE)**
Inventeur: **Verbist, Jacques**
**Avenue de la Vecquée, 66**
**B-5000 Namur(BE)**

(74) Mandataire: **Nichels, William et al**
**Solvay Département de la Propriété Industrielle Rue de Ransbeek, 310**
**B-1120 Bruxelles(BE)**

**EP 0 178 693 B1**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention concerne des polymères conducteurs d'électricité dérivés de monomères polycycliques hétéroaromatiques, ainsi qu'un procédé pour leur préparation.

Elle concerne également des matériaux électroconducteurs composites comprenant des polymères dérivés desdits monomères.

On a déjà proposé de polymériser par voie électrochimique des monomères hétérocycliques aromatiques contenant un hétéroatome tel que le furane, le thiophène, le pyrrole et leurs dérivés substitués (voir brevet US-A-3574072 et Chemica Scripta, 1981, vol. 17 (1-5), pages 145 à 148).

Ces polymères comprennent des chaînes macromoléculaires hydrocarbonées présentant des doubles liaisons conjuguées dont les électrons $\pi$ sont délocalisés sur un grand nombre d'atomes voisins, et cette structure permet de les rendre conducteurs par une opération de "dopage" par laquelle on ionise partiellement la chaîne macromoléculaire en y associant des contre-ions. Cette opération peut s'effectuer au cours même de la synthèse électrochimique du polymère, par incorporation d'un élément ionique de l'électrolyte mis en oeuvre.

Plus récemment, on a décrit (demande de brevet EP-A-0099984) des copolymères conducteurs du pyrrole et d'autres hétérocycles aromatiques présentant une configuration d'électrons conjugués du type $\pi$ , tels que le furane, le thiadiazol et, le thiophène par exemple.

La résistance mécanique et la conductivité électrique de ces copolymères seraient supérieures à celles des homopolymères conducteurs correspondants du pyrrole.

Dans la mesure où les polymères et copolymères mentionnés ci-dessus sont synthétisés par voie électrochimique (oxydation anodique), une de leurs applications les plus importantes est tout naturellement devenue le revêtement d'électrodes de types les plus divers.

L'élargissement du champ de cette application se heurte parfois à des limitations : d'une part, le nombre relativement limité de monomères utilisés et le caractère statistique de la copolymérisation rendent difficilement modulables les propriétés électriques (conductivité) des polymères obtenus; d'autre part le taux de dopage que l'on peut atteindre avec ces polymères sans nuire à leur stabilité est relativement peu élevée, ce qui représente un inconvénient dans le cas du revêtement d'électrodes utilisées dans les dispositifs de stockage d'énergie, notamment dans les batteries d'accumulateurs rechargeables dont la capacité spécifique rapportée à l'unité de poids est alors insuffisante.

La présente invention vise à fournir une nouvelle famille de polymères électroconducteurs ne présentant pas les inconvénients sus-mentionnés.

L'invention concerne à cet effet des polymères conducteurs d'électricité contenant des unités récurrentes dérivées de monomères hétéroaromatiques polycycliques formés de cycles à cinq chaînons condensés dont chaque cycle contient un hétéroatome.

L'invention concerne également un procédé pour la préparation de ces polymères selon lequel on polymérise électrochimiquement, par oxydation anodique au sein d'un solvant polaire et en présence d'un électrolyte approprié, au moins un monomère hétéroaromatique polycyclique formé de cycles à cinq chaînons condensés dont chaque cycle contient un hétéroatome.

Les monomères M utilisables pour préparer les nouveaux polymères selon l'invention contiennent donc des molécules hétéroaromatiques polycycliques, formées de cycles condensés, dont chacun contient cinq chaînons et un hétéroatome. Ces cycles peuvent porter des substituants de nature quelconque, généralement choisis parmi les radicaux alkyle, alkoxy, hydroxyle, aryle, halogénure, cyano, amino et de préférence parmi les radicaux alkyle, tels que le radical méthyle par exemple.

Les hétéroatomes qui sont inclus dans chacun des cycles du monomère hétéroaromatique et qui peuvent être de nature identique ou différente dans chaque cycle sont généralement choisis parmi les atomes d'oxygène, de soufre, d'azote, de sélénium et de phosphore.

Parmi ces monomères M, les monomères bicycliques formés de deux cycles à cinq chaînons condensés constituent une classe préférée, et en particulier ceux représentés par l'une des formules générales ci-après :

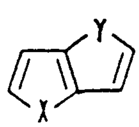

(I)

ou

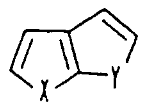

(II)

dans lesquelles X et Y, identiques ou différents, représentent chacun un atome ou groupement choisi parmi le groupe -NH et les atomes de soufre et de sélénium.

La famille des monomères bicycliques utilisables de préférence selon l'invention comprend donc les composés ci-après :

le pyrrolo(2,3-b)pyrrole et le pyrrolo(3,2-b)pyrrole de formules respectives :

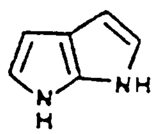

et

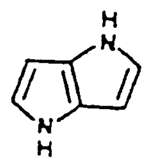

le thiéno(2,3-b)thiophène et le thiéno(3,2-b)thiophène de formules respectives :

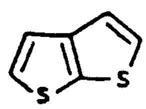

et

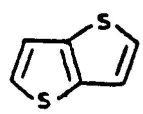

le séléno(2,3-b)sélénophène et le séléno(3,2-b)sélénophène de formules respectives :

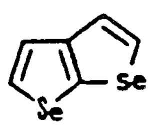

et

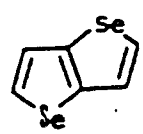

le thiéno(2,3-b)pyrrole et le thiéno(3,2-b)pyrrole de formules respectives :

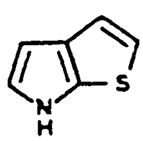

et

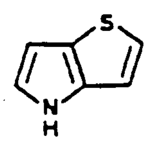

le séléno(2,3-b)pyrrole et le séléno(3,2-b)pyrrole de formules respectives :

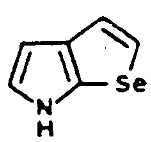

et

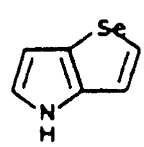

le séléno(2,3-b)thiophène et le séléno(3,2-b)thiophène de formules respectives :

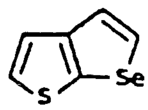 et 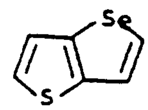

Les monomères utilisables selon l'invention peuvent être synthétisés selon des méthodes connues (voir notamment les références (8) à (13) de l'article de R.Gleiter et Coll. dans Journal of Organic Chemistry, vol. 42, n° 13, 1977, pages 2230 à 2237) et Monat Chem., volume 103, 1972, page 194.

On peut préparer les polymères électroconducteurs de l'invention à partir des monomères sus-mentionnés, utilisés seuls ou en mélanges dans des proportions déterminées par expérimentation en fonction des propriétés recherchées des copolymères en résultant. Selon l'invention, ces monomères ou des mélanges de ces monomères peuvent aussi être polymérisés en présence de proportions variables d'autres comonomères.

A titre d'exemples de pareils comonomères, on peut citer des comonomères cycliques aromatiques et hétéroaromatiques à 5 ou 6 chaînons tels que l'aniline, le pyrrole et le thiophène (et leurs dérivés substitués) et des monomères vinyliques tels que l'acrylonitrile et l'acrylamide. Il est évident que la teneur éventuelle en comonomère du milieu de polymérisation devra être déterminée expérimentalement de manière à éviter toute détérioration des propriétés électriques et mécaniques des polymères.

La préparation des polymères selon l'invention s'effectue par polymérisation électrochimique, généralement dans une cellule d'électrolyse, par oxydation anodique du ou des monomères au sein d'un solvant polaire et en présence d'électrolytes appropriés suivant des techniques conventionnelles (voir exemple K.K. Kanazawa et Coll., Synthetic Metals, vol. 1 (1979/80), pages. 329-336 et demande de brevet européen EP-A-0099984).

Selon ces techniques, la concentration en monomères est généralement comprise entre $10^{-3}$ et $10^{-1}$ mole par litre de solvant.

Comme solvants, on utilise de préférence des solvants polaires possédant des propriétés dissolvantes à la fois vis à vis du ou des monomères et de l'électrolyte choisi et stables dans le domaine des potentiels appliquées. Des exemples de solvants utilisables sont l'acétonitrile, le tétrahydrofurane et le chlorure de méthylène.

Les électrolytes sont généralement choisis parmi les sels conducteurs de formule $C^+A^-$ dans laquelle $C^+$ est un cation et dans laquelle $A^-$ est un anion.

Le cation $C^+$ est choisi de préférence parmi les ions alcalins, les ions $R_4N^+$ et $R_4P^+$ (R étant un radical alkyle, tel que les radicaux éthyle et butyle par exemple).

L'anion $A^-$ est choisi de préférence parmi les ions $C10_4^-$, $AsF_6^-$, $SbF_6^-$, $SO_4^{2-}$, $C_6H_5COO^-$, $C_6H_5SO_3^-$, $BF_4^-$, $PF_6^-$, $I^-$ et $Br^-$.

Des électrolytes typiques sont par exemple les fluoroborates, tels que le tétrafluoroborate de tétraéthylammonium et les perchlorates, tel que le perchlorate de lithium.

La concentration en électrolyte est généralement comprise entre $10^{-2}$ et 1 mole par litre de solvant.

La cellule électrochimique au sein de laquelle peut s'effectuer la polymérisation des monomères selon l'invention peut fonctionner dans des conditions potentiostatiques ou galvanostatiques.

Dans le premier cas (contrôle potentiostatique), la cellule comprend, outre la source de courant externe, trois électrodes dont une électrode de référence de contrôle du potentiel.

Au cours de l'électrolyse, une couche de polymère se dépose sur l'élément conducteur utilisé comme anode de la cellule d'électrolyse. Cette anode peut être réalisée en un métal noble, tel que l'or ou le platine, ou en un autre métal, tel que le cuivre, éventuellement doré ou platiné, le titane ou le nickel. Après l'électrolyse, on dispose donc en fait d'une électrode constituée par un corps conducteur enrobé par un film de polymère y adhérant et qui contient une certaine proposition de l'anion provenant de l'électrolyte. La composition chimique de ce film de polymère peut être représentée par la formule empirique $(M^+A_y^-)_n$ où M représente le monomère, $A^-$ l'anion ou contre-ion, y la proportion en anion dans le polymère exprimée par unité monomérique(c'est-à-dire le taux de dopage) qui, dans le cas des polymères de l'invention peut atteindre aisément la valeur de 0,5, et n le degré de polymérisation généralement impossible à déterminer aisément, compte tenu du caractère insoluble du polymère.

Le polymère et l'anion forment ainsi un complexe à transfert de charges, dont la conductivité, largement modulable par le choix de la nature du ou des monomères de départ peut varier entre environ $10^{-3}$ et environ $10^2 \Omega^{-1}$ $cm^{-1}$.

Une variante préférée du procédé pour la préparation de polymères électroconducteurs selon l'invention, consiste à utiliser une anode en un matériau choisi parmi le carbone et les polymères organiques à doubles liaisons conjuguées, à l'exception de ceux dérivés de monomères hétéroaromatiques polycycliques. Ces polymères organiques sont généralement choisis parmi les polymères dérivés de l'acétylène, les polymères dérivés de monomères aromatiques monocycliques, tels que le polyparaphénylène, la polyaniline, le polysulfure et le polyoxyde de phénylène par exemple, et les polymères dérivés de monomères hétéroaromatiques monocycliques tels que le polypyrrole, le polythiophène, le poly-3-méthylthiophène, et le polyfurane par exemple. Les polymères préférés sont les polymères dérivés de l'acétylène.

Ces polymères peuvent être rendus conducteurs par toute méthode connue, par exemple par dopage positif par action d'agents oxydants chimiques, tels que les pentafluorures de phosphore et d'arsenic et les trichlorures d'indium et de fer ou par oxydation électrochimique dans une solution d'un électrolyte tel que ceux mentionnés plus haut.

La préparation des polymères électroconducteurs de l'invention en présence d'une anode en l'un des matériaux définis ci-dessus conduit à des matériaux électroconducteurs composites, qui constituent également un objet de la présente invention.

Ces matériaux électroconducteurs composites comprennent une association d'un substrat et d'au moins un polymère électroconducteur dérivé des monomères hétéroaromatiques polycycliques définis plus haut.

La nature du substrat de ces matériaux est évidemment conditionnée par la nature de l'anode en présence de laquelle les polymères conducteurs d'électricité de l'invention ont été synthétisés. Ce substrat peut être donc généralement constitué d'un métal, de carbone, ou d'un polymère organique à doubles liaisons conjuguées tels que définis plus haut. Des substrats résultant de mélanges ou de combinaisons de ces constituants, tels que des alliages de métaux, des mélanges de polymères organiques, des métaux recouverts de ces polymères organiques, etc. peuvent également entrer dans la composition des matériaux électroconducteurs de l'invention.

On cite ci-après, à titre exemplatif et non limitatif, quelques applications des matériaux électroconducteurs composites de l'invention, en fonction de la nature du substrat.

Dans le cas de substrats métalliques, ces matériaux sont utilisables comme électrodes protégées contre la corrosion, telles que par exemple des photoélectrodes utilisées pour la décomposition de l'eau par l'énergie solaire.

Dans le cas de substrats en carbone, lorsque ce dernier est sous forme de fibres, par exemple, ces matériaux sont utilisables pour la confection de microélectrodes à usage médical, grâce à la possibilité d'effectuer un dépôt microscopique du polymère électroconducteur sur le substrat.

Dans le cas de sustrats à base des polymères à doubles liaisons conjuguées définis plus haut, les matériaux électroconducteurs composites de l'invention peuvent être utilisés dans toutes les applications connues de ces polymères, avec l'avantage que l'on peut en moduler les propriétés dans une très large mesure par le choix de la nature, du type de dopage et de l'épaisseur de la couche de polymère électroconducteur enrobant et, d'autre part, avec l'avantage supplémentaire que cette couche même protège le polymère du substrat.

Ce dernier avantage est particulièrement apprécié dans le cas où le polymère du substrat est le polyacétylène éminemment sensible à l'oxydation par l'air.

On peut donc utiliser ces matériaux pour la fabrication de cellules photovoltaïques, d'électrodes positives pour dispositifs de stockage d'énergie électrique rechargeables ou non (batteries et piles); dans le cas de dépôts des polymères électroconducteurs enrobants faiblement dopés en couches minces, on peut utiliser ces matériaux en microélectronique pour la fabrication de jonctions, de barrières Schottky et de transistors grâce à leurs propriétés de semi-conducteurs du type N ou P suivant la nature du dopage; les cycles de dopage-dédopage de ces matériaux peuvent être mis à profit pour leur utilisation dans la fabrication d'éléments de mémoires optiques, de disposifs opto-électroniques, de commutateurs, etc.

L'invention est illustrée mais non limitée par l'exemple suivant.

Exemple

1 - On prépare du polyacétylène par la méthode décrite dans J. Polym. Sci., Polym. Chem. Ed., 1974, vol. 12, pages 11 à 20 et on le dope par le chlorure ferrique comme indiqué dans Journal de Physique, Colloque C3, supplément au numéro 6, tome 44, juin 1983, page C 3-3.

2 - Du thiéno (2,3-b) pyrrole préparé selon H. Hemetsberger et coll. (Monat Chem., volume 103, 1972, page 194) est polymérisé électrochimiquement par oxydation anodique sous conditions potentiostatiques dans une cellule à un compartiment traversée par un courant de 5 mA et comprenant trois électrodes.

L'anode est réalisée en polyacétylène dopé préparé comme indiqué en 1 et le potentiel de l'anode est fixé à 0,8 V par rapport à l'électrode de référence ($Ag/AgNO_3$ $10^{-1}$ M). La cathode est en or.

La solution électrolytique consiste en tétrafluoroborate de tétraéthylammonium (0,1 M) et en thiéno (3,2-b) pyrrole (0,05 M) dans l'acétonitrile. Cette solution est désoxygénée par passage d'argon pendant 30 min

préalablement à la polymérisation. La polymérisation est poursuivie pendant 5 minutes sous atmosphère d'argon.

A l'issue de l'essai, le matériau recueilli, constitué de l'anode revêtue d'un film gris de polythiénopyrrole présente une conductivité spécifique de l'ordre de 100 $\Omega^{-1}$ $cm^{-1}$.

## Revendications

1. Polymères conducteurs d'électricité contenant des unités récurrentes dérivées de monomères hétéroaromatiques polycycliques formés de cycles à cinq chaînons condensés dont chaque cycle contient un hétéroatome.

2. Polymères conducteurs selon la revendication 1, caractérisés en ce que les monomères hétéroaromatiques polycycliques sont des monomères bicycliques formés de deux cycles à cinq chaînons condensés représentés par l'une des formules générales

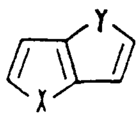

(I)

ou

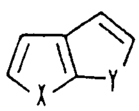

(II)

dans lesquelles X et Y, identiques ou différents, représentent chacun un atome ou groupement choisi parmi le groupe -NH et les atomes de soufre et de sélénium.

3. Procédé pour la préparation de polymères électroconducteurs caractérisé en ce que l'on polymérise électrochimiquement, par oxydation anodique au sein d'un solvant polaire et en présence d'un électrolyte appropriée, au moins un monomère hétéroaromatique polycyclique formé de cycles à cinq chaînons condensés dont chaque cycle contient un hétéroatome.

4. Procédé selon la revendication 3, caractérisé en ce que le monomère hétéroaromatique polycyclique est un monomère bicyclique formé de deux cycles à cinq chaînons condensés représentés par l'une des formules générales

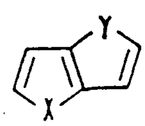

(I)

ou

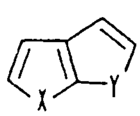

(II)

dans lesquelles X et Y, identiques ou différents, représentent chacun un atome ou groupement choisi parmi le groupe -NH et les atomes de soufre et de sélénium.

**5.** Procédé selon la revendication 3, caractérisé en ce que l'on polymérise électrochimiquement le monomère en présence d'une anode en carbone.

**6.** Procédé selon la revendication 3, caractérisé en ce que l'on polymérise électrochimiquement le monomère en présence d'une anode réalisée en un polymère organique à doubles liaisons conjuguées, à l'exception de ceux dérivés de monomères hétéroaromatiques polycycliques.

**7.** Procédé selon la revendication 6, caractérisé en ce que le polymère organique à doubles liaisons conjuguées est un polymère dérivé de l'acétylène.

**8.** Matériaux électroconducteurs composites comprenant une association d'un substrat et d'au moins un polymère dérivé de monomères hétéroaromatiques formés de cycles à cinq chaînons condensés dont chaque cycle contient un hétéroatome.

**9.** Matériaux selon la revendication 8, caractérisés en ce que le polymère est dérivé de monomères bicycliques formé de deux cycles à cinq chaînons condensés représentés par l'une des formules générales

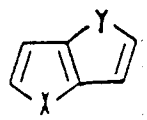

(I)

ou

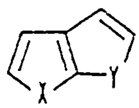

(II)

dans lesquelles X et Y, identiques ou différents, représentent chacun un atome ou groupement choisi parmi le groupe -NH et les atomes de soufre et de sélénium.

**10.** Matériaux selon la revendication 8, caractérisés en ce que le substrat est un métal.

**11.** Matériaux selon la revendication 8, caractérisés en ce que le substrat est constitué de fibres de carbone.

**12.** Matériaux selon la revendication 8, caractérisés en ce que le substrat est un polymère à doubles liaisons conjuguées à l'exception de ceux dérivés de monomères hétéroaromatiques polycycliques.

**13.** Matériaux selon la revendication 12, caractérisé en ce que le polymère organique est du polyacétylène rendu conducteur par dopage positif.

**Claims**

**1.** Electrically conductive polymers containing repeat units derived from polycyclic heteroaromatic monomers consisting of condensed five-membered rings in which each ring contains a heteroatom.

**2.** Conductive polymers according to Claim 1, characterised in that the polycyclic heteroaromatic monomers are bicyclic monomers consisting of two condensed five-membered rings denoted by one of the general formulae

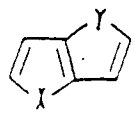

(I)

or

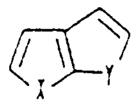

(II)

in which each of X and Y, which are identical of different, denotes an atom or group chosen from the -NH group and sulphur and selenium atoms.

**3.** Process for the preparation of electroconductive polymers, characterised in that at least one polycyclic heteroaromatic monomer consisting of condensed five-membered rings in which each ring contains a heteroatom is polymerised electrochemically by anodic oxidation in a polar solvent and in the presence of an appropriate electrolyte.

**4.** Process according to Claim 3, characterised in that the polycyclic heteroaromatic monomer is a bicyclic monomer consisting of two condensed five-membered rings denoted by one of the general formulae

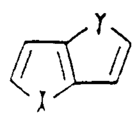

(I)

or

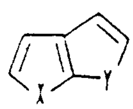

(II)

in which each of X and Y, which are identical or different, denotes an atom or group chosen from the -NH group and sulphur and selenium atoms.

**5.** Process according to Claim 3, characterised in that the monomer is polymerised electrochemically in the presence of a carbon anode.

**6.** Process according to Claim 3, characterised in that the monomer is polymerised electrochemically in the presence of an anode made of an organic polymer containing conjugated double bonds, with the exception of those derived from polycyclic heteroaromatic monomers.

**7.** Process according to Claim 6, characterised in that the organic polymer containing conjugated double bonds is a polymer derived from acetylene.

**8.** Composite electroconductive materials comprising a combination of a substrate and of at least one polymer derived from heteroaromatic monomers consisting of condensed five-membered rings in which each ring contains a heteroatom.

**9.** Materials according to Claim 8, characterised in that the polymer is derived from bicyclic monomers

consisting of two condensed five-membered rings denoted by one of the general formulae

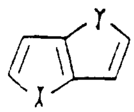

(I)

or

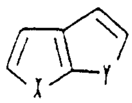

(II)

in which each of X and Y, which are identical or different, denotes an atom or group chosen from the -NH group and sulphur and selenium atoms.

**10.** Materials according to Claim 8, characterised in that the substrate is a metal.

**11.** Materials according to Claim 8, characterised in that the substrate consists of carbon fibres.

**12.** Materials according to Claim 8, characterised in that the substrate is a polymer containing conjugated double bonds with the exception of those derived from polycyclic heteroaromatic monomers.

**13.** Materials according to Claim 12, characterised in that the organic polymer is polyacetylene made conductive by positive doping.

## Patentansprüche

**1.** Elektroleitende Polymere, die wiederkehrende, von heteroaromatischen, polyzyklischen Monomeren abgeleitete Einheiten enthalten, gebildet aus kondensierten Ringen mit fünf Gliedern, wobei jeder Ring ein Heteroatom enthält.

**2.** Leitende Polymere nach Anspruch 1, dadurch gekennzeichnet, daß die heteroaromatischen, polyzyklischen Monomere bizyklische Monomere sind, die aus zwei kondensierten Ringen mit fünf Gliedern gebildet sind, die durch eine der folgenden allgemeinen Formeln dargestellt werden

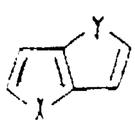

(I)

oder

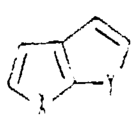

(II)

in denen X und Y, gleich oder unterschiedlich, jeweils ein Atom oder eine Gruppierung, ausgewählt aus der Gruppe -NH und den Atomen Schwefel und Selen, darstellen.

**3.** Verfahren zur Herstellung von elektroleitenden polymeren, dadurch gekennzeichnet, daß man wenigstens ein heteroaromatisches, polyzyklisches Monomer, bestehend aus kondensierten Ringen mit fünf Gliedern, wobei jeder Ring ein Heteroatom enthält, durch anodische Oxidation in einem polaren

Lösungsmittel und in Anwesenheit eines geeigneten Elektrolyten elektrochemisch polymerisiert.

4. Verfahren nach Anspruch 3, dadurch gekennzeichnet, daß das heteroaromatische, polyzyklische Monomer ein bizyklisches Monomer aus zwei kondensierten Ringen mit fünf Gliedern ist, die durch eine der allgemeinen Formeln dargestellt werden

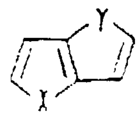

(I)

oder

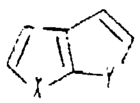

(II)

in denen X und Y, gleich oder unterschiedlich, jeweils ein Atom oder eine Gruppierung, ausgewählt aus der Gruppe -NH und den Atomen Schwefel und Selen, darstellen.

5. Verfahren nach Anspruch 3, dadurch gekennzeichnet, daß man das Monomer in Anwesenheit einer Kohlenstoffanode elektrochemisch polymerisiert.

6. Verfahren nach Anspruch 3, dadurch gekennzeichnet, daß man das Monomer in Anwesenheit einer Anode aus einem organischen Polymer mit konjugierten Doppelbindungen, mit Ausnahme der Derivate von heteroaromatischen, polyzyklischen Monomeren, elektrochemisch polymerisiert.

7. Verfahren nach Anspruch 6, dadurch gekennzeichnet, daß das organische Polymer mit konjugierten Doppelbindungen ein von Acetylen abgeleitetes Polymer ist.

8. Elektroleitende Verbundmaterialien umfassend einen Verbund aus einem Substrat und wenigstens einem polymer, abgeleitet von heteroaromatischen Monomeren, die aus kondensierten Ringen mit fünf Gliedern, wobei jeder Ring ein Heteroatom enthält, gebildet sind.

9. Materialien nach Anspruch 8, dadurch gekennzeichnet, daß das Polymer von bizyklischen Monomeren abgeleitet ist, die aus zwei kondensierten Ringen mit fünf Gliedern gebildet sind, die durch eine der allgemeinen Formeln dargestellt werden

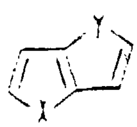

(I)

oder

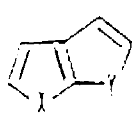

(II)

in denen X und Y, gleich oder unterschiedlich, jeweils ein Atom oder eine Gruppierung, ausgewählt aus der Gruppe -NH und den Atomen Schwefel und Selen, darstellen.

10. Materialien nach Anspruch 8, dadurch gekennzeichnet, daß das Substrat ein Metall ist.

11. Materialien nach Anspruch 8, dadurch gekennzeichnet, daß das Substrat aus Kohlenstoffasern gebildet

ist.

**12.** Materialien nach Anspruch 8, dadurch gekennzeichnet, daß das Substrat ein Polymer mit konjugierten Doppelbindungen ist, mit Ausnahme der Derivate von heteroaromatischen, polyzyklischen Monomeren.

**13.** Materialien nach Anspruch 12, dadurch gekennzeichnet, daß das organische Polymer durch positives Dotieren leitend gemachtes Polyacetylen ist.